# EUROPÄISCHE PATENTSCHRIFT

(11) **EP 3 084 517 B1**
(45) Veröffentlichungstag und Bekanntmachung des Hinweises auf die Patenterteilung: **13.03.2019**
(21) Anmeldenummer: 14838908.3
(22) Anmeldetag: 17.12.2014
(51) Int. Cl.: G02F 1/15, B22F 3/10, C23C 14/34, C22C 1/04, C22C 27/04, C22F 1/10, C22F 1/18, H01J 37/34, C22C 19/03

(54) **W-NI-SPUTTERTARGET**
W-NI SPUTTER TARGET
CIBLE W-NI DE PULVÉRISATION CATHODIQUE

(30) Priorität: 20.12.2013 AT 4562013 U
(43) Veröffentlichungstag der Anmeldung: 26.10.2016
(73) Patentinhaber: Plansee SE, 6600 Reutte (AT)
(72) Erfinder: LINKE, Christian, 6600 Ehenbichl (AT); SCHERER, Thomas, 6600 Lechaschau (AT)
(74) Vertreter: Ciesla, Bettina
(86) Internationale Anmeldenummer: PCT/AT2014/000225
(87) Internationale Veröffentlichungsnummer: WO 2015/089533

(56) Entgegenhaltungen:
- LEE S-H ET AL: "ELECTROCHROMIC BEHAVIOR OF NI-W OXIDE ELECTRODES", SOLAR ENERGY MATERIALS AND SOLAR CELLS, ELSEVIER SCIENCE PUBLISHERS, AMSTERDAM, NL, Bd. 39, Nr. 2/04, 1. Dezember 1995 (1995-12-01), Seiten 155-166, XP000586153, ISSN: 0927-0248, DOI: 10.1016/0927-0248(95)00046-1 in der Anmeldung erwähnt

## Beschreibung

Die Erfindung betrifft ein W-Ni Sputtertarget sowie seine Verwendung für die Herstellung elektrochromer Schichten. Weiterhin betrifft die Erfindung ein Verfahren zur Herstellung eines W-Ni Sputtertargets über die pulvermetallurgische Route.

Elektrochromes Verhalten kann breit als eine anhaltende und reversible Änderung der optischen Eigenschaften eines Materials, welche durch ein angelegtes elektrisches Feld oder einen elektrischen Strom induziert wird, definiert werden. Vorteile einer solcherart entstandenen farblichen Veränderung sind beispielsweise sehr hohe mögliche Kontraste bei gleichzeitig kurzen Schaltzeiten sowie keine Einschränkung bezüglich des Sichtwinkels auf das elektrochrome Material. Diese Vorteile machen elektrochrome Materialien, insbesondere elektrochrome Schichten, interessant für den Einsatz in elektrochromen Displays und in weiterer Folge zum Beispiel für intelligente Gläser ("Smart Glass").

Elektrochrome Schichten bzw. Schichtsysteme können über Verfahren der physikalischen Gasphasenabscheidung (physical vapor deposition = PVD) hergestellt werden. Dabei handelt es sich um ein Verfahren zur Beschichtung, bei dem die Schichtbildung durch Überführen der schichtbildenden Teilchen aus einem Target in die Gasphase und der Kondensation auf dem zu beschichtenden Substrat stattfindet. Ziel des Verfahrens ist es, homogene Schichten mit gleichmäßiger Schichtdicke sowie homogener Zusammensetzung abzuscheiden.

Schichten die bekanntermaßen elektrochromes Verhalten zeigen sind zum Beispiel die Übergangsmetalloxide WO₃, MoO₃, V₂O₅, TiO₂, Nb₂O₅ und NiOₓH_{y}. Wolframoxid WO₃ wird durch den Einbau von H⁺ oder Li⁺ Ionen kathodisch gefärbt, NiOₓ hingegen kathodisch durch den Einbau von Li⁺ Ionen entfärbt. Die Kombination dieser beiden Oxide als Elektrodenschichten ist für den Einsatz in effizienten elektrochromen Displays oder Gläsern optimal. Eine weitere Verbesserung kann dadurch erzielt werden, wenn zum Beispiel an Stelle von reinen NiOₓ Schichten W-Ni Mischoxidschichten verwendet werden, da damit das Schaltverhalten und die Stabilität der elektrochromen Displays weiter verbessert werden kann.

Elektrochrome Schichten aus W-Ni Mischoxiden sind bereits seit vielen Jahren bekannt und wurden zum Beispiel in "*Lee*, *Electrochromic behavior of Ni-W oxide electrodes*, *Solar Energy Materials and Solar Cells 39 (**1995**)155-166*" beschrieben. Darin findet sich auch ein besonders vorteilhaftes atomares Verhältnis von W/Ni im mit W legierten NiOₓ (W-Ni-Mischoxid) von etwa 0,33. Bei diesem Verhältnis ist der Ladungstransferwiderstand optimal um ein möglichst schnelles optisches Schaltverhalten der elektrochromen Schicht zu gewährleisten.

Für dieserart hergestellte elektrochrome Schichten werden zum Beispiel Sputtertargets aus W-Ni Legierungen eingesetzt, die über reaktives Magnetron-Sputtern unter Sauerstoff zu W-Ni Mischoxidschichten abgetragen werden. Auch oxidische Targets sind bereits aus dem Stand der Technik bekannt. Die Herstellung elektrochromer Vorrichtungen, wie zum Beispiel elektrochromer Gläser, ist beispielsweise in der EP 1 696 261 A1 oder auch der US 2010 0245973 A1 beschrieben.

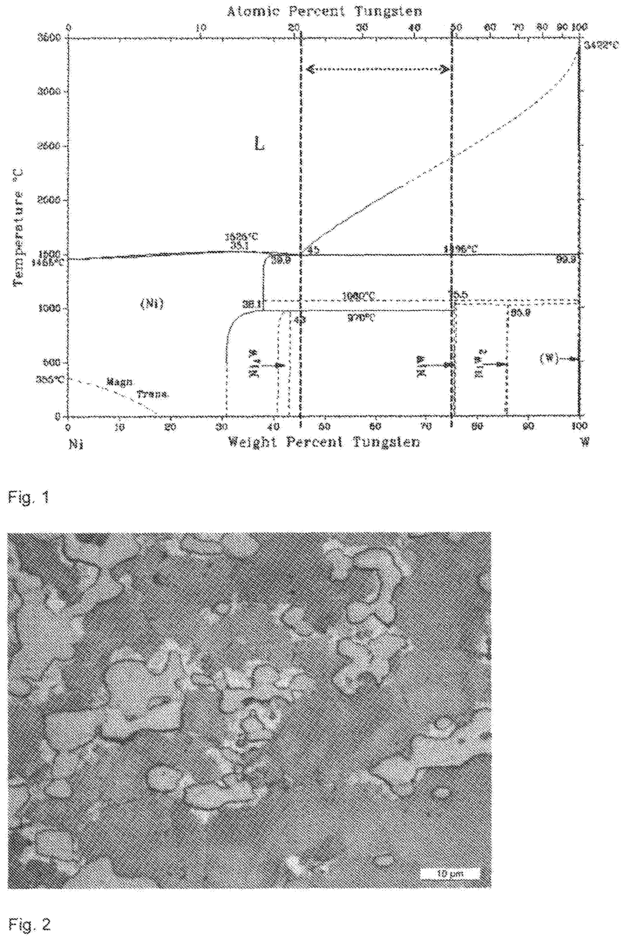

Die Abscheidung von Ni-Oxidschichten zur Herstellung eines elektrochromen Materials von einem hauptsächlich metallischen Target ist in der WO 2000 71777 A1 beschrieben. Durch geringe Zugaben eines weiteren Elements wird eine Verringerung oder Vermeidung des Ferromagnetismus im Target angestrebt. Dies erfolgt beispielsweise bei einer Zugabe von W in Ni von etwa 7at%, durch eine Erniedrigung der Curietemperatur des Ni-Mischkristalls. Dieser Zusammenhang ist auch deutlich aus dem W-Ni Phasendiagramm (siehe Figur 1) ersichtlich.

Derzeit eingesetzte Sputtertargets aus W-Ni Legierungen werden bevorzugt über thermisches Spritzen hergestellt. Die Verwendung von Ni- und W-Pulver als Ausgangsmaterial zur Fertigung der Targets hat zur Folge, dass teilweise reines Nickel im Targetmaterial vorliegt, welches ferromagnetische Eigenschaften zeigt. Diese ferromagnetischen Bereiche sind für das Magnetron-Sputtern von Nachteil, da sich dadurch unterschiedliche Beschichtungsraten ergeben und damit die Homogenität der abgeschiedenen Schicht nachteilig beeinflusst wird.

Zudem sind bei thermischen Spritzverfahren nur begrenzt hohe Materialdichten einstellbar. Niedrige Dichten des Sputtertargetmaterials beeinflussen ebenfalls die Beschichtungsraten negativ. Weiters sind mittels thermischen Spritzens nur begrenzte Materialstärken einstellbar, was die Materialausnutzung und Einsatzdauer der Targets limitiert.

Ein weiterer Nachteil sind die herstellbedingt im Spritzpulver enthaltenen metallischen Verunreinigungen, die sich im hergestellten Targetmaterial direkt abbilden. Verunreinigungen in den gesputterten Schichten können die optischen Schichteigenschaften nachteilig beeinflussen.

Zusätzliche nichtmetallische, insbesondere oxidische oder dielektrische Einschlüsse oder Phasen, die beim thermischen Spritzen in das Targetmaterial eingelagert werden können, führen zu einer erhöhten Partikelanzahl beim Sputtern, die wiederum die Eigenschaften der gesputterten Schicht (Haftung, spezifischer elektrischer Widerstand, Schichthomogenität) und den Beschichtungsprozess (hohe Arc-Raten) nachteilig beeinflussen können.

Weitere Möglichkeiten zur Herstellung von Sputtertargets aus W und Ni sind in der JP 2000 169923 A, der US 2009 022614 A1, der JP 2009 155722 A sowie der WO 2010 119785 A1 angeführt. Die JP 2000 169923 A beschreibt die schmelzmetallurgische Herstellung, die US 2009 022614 A1 und die JP 2009 155722 A beschreiben die pulvermetallurgische Herstellung von W-Ni Sputtertargets mit geringen W-Gehalten unter 20at% (44wt%). Die WO 2010 119785 A1 zeigt die Herstellung von W-Ni Sputtertargets mit sehr hohen W-Gehalten von mehr als 70at% (88wt%).

Wie bereits oben beschrieben sind ausreichend hohe Verhältnisse an W/Ni, zum Beispiel 0,33, für eine Anwendung in elektrochromen Schichten optimal. Dieses Verhältnis entspricht einem W-Gehalt in Ni von etwa 50 wt%. Wie aus dem Phasendiagramm (siehe Figur 1) ersichtlich treten bereits bei W-Gehalten von etwa 30 wt% intermetallische Phasen auf. Insbesondere ist ein Auftreten der spröden Ni₄W Phase unvermeidlich, bei noch höheren W-Gehalten können auch beispielsweise NiW oder NiW₂ vorliegen.

Mit dem Begriff intermetallische Phasen werden Phasen bezeichnet, die in binären, ternären oder auch Mehrstoffsystemen auftreten und deren Existenzbereich sich nicht bis zu den reinen Komponenten fortsetzt. Sie besitzen häufig von den Kristallstrukturen der reinen Komponenten abweichende Kristallstrukturen sowie Anteile nichtmetallischer Bindungstypen. Intermetallische Phasen sind vor allem durch eine wertigkeitsfremde Zusammensetzung und einen endlichen Homogenitätsbereich, das heißt eine enge stöchiometrische Zusammensetzung gekennzeichnet. Intermetallische Phasen sind häufig spröd, besitzen also geringe Zähigkeit was sich in weiterer Folge meist nachteilig auf das Targetmaterial auswirkt.

Die Aufgabenstellung der Erfindung ist es, ein W-Ni Sputtertarget mit einem für die beschriebene Anwendung optimalen Zusammensetzungsbereich sowie Eigenschaftsprofil und Gefüge (auch Mikrostruktur) unter Vermeidung der erwähnten Nachteile bereitzustellen. Weiters ist es Aufgabe der Erfindung, ein Herstellverfahren für ein W-Ni Sputtertarget unter Vermeidung der erwähnten Nachteile bereitzustellen. Das erfindungsgemäße Herstellverfahren soll die Herstellung eines W-Ni Sputtertargets mit hohem Reinheitsgrad sowie homogenem und feinkörnigem Gefüge ermöglichen. Weiters soll das Herstellverfahren kostengünstig und reproduzierbar sein.

Gelöst wird die Aufgabe durch die unabhängigen Ansprüche. Vorteilhafte Ausgestaltungen ergeben sich aus den abhängigen Ansprüchen.

Ein erfindungsgemäßes Sputtertarget enthält zwischen 45 und 75 wt% W, Rest Ni sowie übliche Verunreinigungen. Es ist dadurch gekennzeichnet, dass es Ni(W)-Phase, W-Phase sowie keinen oder unter 10% an einer Schnittfläche des Targetmaterials gemessenen mittleren Flächenanteil intermetallischer Phasen enthält.

Bei der Ni(W)-Phase handelt es sich, wie auch aus dem Phasendiagramm (Figur 1) ersichtlich, um reine Ni-Phase oder mit W legierten Ni-Mischkristall, bevorzugt um mit W gesättigten Ni-Mischkristall. Eine Sättigung mit W ist bei etwa 35wt% (15at%) gegeben (siehe Figur 1). Die W-Phase hat hingegen nur eine sehr geringe Löslichkeit für Ni.

Bei den intermetallischen Phasen kann es sich beispielsweise um die intermetallische Ni₄W Phase handeln, es ist jedoch auch das Auftreten anderer intermetallischer Phasen (NiW, NiW₂) im System Ni-W und insbesondere im angestrebten Zusammensetzungsbereich möglich. Ein Anteil an intermetallischen Phasen von größer 10% kann einerseits dazu führen, dass durch die zum restlichen Target unterschiedliche Sputterrate intermetallischer Phasen ein ungleichmäßiger Abtrag über das Targetmaterial und damit Schwankungen in der Dicke der abgeschiedenen Schicht entstehen. Weiters können im Gefüge des Targetmaterials vorhandene intermetallische spröde Phasen zu Arcing (lokales Aufschmelzen durch Entstehung eines Lichtbogens) oder verstärkter Partikelbildung führen. Andererseits wird durch die geringe Zähigkeit der intermetallischen Phasen die Handhabung des Targets erschwert.

Bevorzugt enthält ein erfindungsgemäßes Sputtertarget unter 5% an einer Schnittfläche des Targetmaterials gemessenen mittleren Flächenanteil intermetallischer Phasen.

Das Auftreten intermetallischer Phasen in einem erfindungsgemäßen Sputtertarget kann sehr einfach mittels Röntgendiffraktometrie (XRD) (unter Berücksichtigung der jeweiligen röntgenographischen Nachweisgrenze) unter Verwendung der relevanten JCPDS-Karten nachgewiesen oder ausgeschlossen werden.

Für die Bestimmung des Anteils an intermetallischen Phasen den ein erfindungsgemäßes Sputtertarget enthält, wird der mittlere Flächenanteil an einer Schnittfläche analysiert. Dafür wird ein metallographischer Schliff hergestellt und licht- oder elektronenmikroskopisch untersucht. Ein metallographischer Schliff ist als zweidimensionaler Schnitt durch das dreidimensionale Targetmaterial zu verstehen. Mittels kommerziell erhältlicher Bildauswertesoftwares können an so erzeugten mikroskopischen Aufnahmen Flächenanalysen durchgeführt werden. Dies erfolgt über eine Bildanalyse zur Bestimmung einzelner Phasenanteile des genannten Gefüges typischerweise über eine Kontrastierung der zu unterscheidenden Phasen. Mittels geeigneter Ätzverfahren können schwer unterscheidbare Phasen weiter kontrastiert werden. Im vorliegenden Fall ist die intermetallische Ni₄W Phase über Ätzen mit einer entsprechend geeigneten Ätzlösung (z.B. 85 ml Ammoniaklösung und 5 ml Wasserstoffperoxid 30%ig) vom Ni-Mischkristall (Ni(W)-Phase, mit W gesättigter Ni-Mischkristall) unterscheidbar und es kann der Flächenanteil bestimmt werden. Je nach Gefügezustand sind aber auch alternative Ätzlösungen und Verfahren denkbar. Der mittlere Flächenanteil wird als arithmetisches Mittel aus 5 Messungen des Flächenanteils gemessen an 5 Bildausschnitten mit einer Größe von 100 x 100µm eines metallographischen Schliffes, aufgenommen mit 1000-facher Vergrößerung, berechnet.

Das Auftreten intermetallischer Phasen hat jedoch keinen Nachteil in Bezug auf die magnetischen Eigenschaften eines erfindungsgemäßen Sputtertargets, da die im System W-Ni auftretenden Ni-enthaltenden intermetallischen Phasen nicht ferromagnetisch sind.

Bei einem W-Gehalt in einem Sputtertarget von kleiner 45 wt% tritt, wie aus dem Phasendiagramm in Figur 1 ersichtlich, bevorzugt die spröde Ni₄W Phase auf. Bei noch geringeren Anteilen an W kann es bereits zum Auftreten von ferromagnetischer Ni-Phase kommen. Bei W-Gehalten von größer 75 wt% ist die Härte des Targetmaterials bereits zu hoch, um eine optimale und wirtschaftliche Verarbeitbarkeit gewährleisten zu können. Weiters ist das Auftreten der intermetallischen Phasen NiW und NiW₂ bei diesen Gehalten bereits stark begünstigt. Zusätzlich kann bei W Gehalten von kleiner 45 wt% sowie größer 75 wt% das für eine optimale Funktionsweise einer mittels eines Sputtertarget abgeschiedenen elektrochromen Schicht erforderliche W/Ni Verhältnis nicht mehr optimal erreicht werden.

Mit üblichen Verunreinigungen werden herstellbedingte Verunreinigungen an Gasen oder begleitenden Elementen bezeichnet, die aus den verwendeten Rohstoffen stammen. Der Anteil solcher Verunreinigungen in einem erfindungsgemäßen Sputtertarget liegt bevorzugt im Bereich von unter 100 µg/g (entspricht ppm) für Gase (C, H, N, O), sowie unter 500 µg/g für andere Elemente. Geeignete Verfahren zur chemischen Elementanalyse sind bekanntlich abhängig vom zu analysierenden chemischen Element. Für die chemische Analyse eines erfindungsgemäßen leitfähigen Targetmaterials wurden ICP-OES (Optische Emissionsspektrometrie mit induktiv gekoppeltem Plasma), RFA (Röntgenfluoreszenzanalyse) und GDMS (Glow Discharge Mass Spectrometry) verwendet.

Ein erfindungsgemäßes Sputtertarget weist bevorzugt einen Sauerstoffgehalt auf der unter 100 µg/g, besonders bevorzugt unter 90 µg/g, weiter bevorzugt unter 75 µg/g, noch weiter bevorzugt unter 50 µg/g liegt.

Der Sauerstoffgehalt kann einfach über ICP-OES bestimmt werden.

Ein erfindungsgemäßes Sputtertarget ist dadurch gekennzeichnet, dass dessen Härte bevorzugt unter 500 HV10 liegt.

Es hat sich herausgestellt, dass bei Härten von kleiner 500 HV10 eine ausreichende Zähigkeit des Targetmaterials optimal gewährleistet werden kann. Dadurch wird die Handhabung während des Herstellprozesses vereinfacht, beispielsweise bei einer optional durchgeführten mechanischen Bearbeitung. Auch während des Einsatzes, vor allem in einer Ausführungsform als einteiliges Rohrtarget, ergibt sich durch eine Härte von kleiner 500 HV10 eine signifikante Vereinfachung in Bezug auf die Handhabung.

Die Härte in HV10 (Vickershärte) ist hier als arithmetisches Mittel ermittelt aus 5 Härtemessungen zu verstehen.

Ein erfindungsgemäßes Sputtertarget weist bevorzugt eine relative Dichte von mehr als 96% auf. Besonders vorteilhaft ist eine relative Dichte von mehr als 99%.

Je höher die Dichte des Targets umso vorteilhafter sind dessen Eigenschaften. Targets mit geringer relativer Dichte weisen einen höheren Anteil an Poren auf, welche ein virtuelles Leck und oder eine Quelle von Verunreinigungen und Partikeln während des Sputterprozesses sein können. Außerdem neigen Targets mit geringer Dichte dazu, Wasser sowie andere Verunreinigungen aufzunehmen, was infolgedessen zu schwer kontrollierbaren Prozessparametern führen kann. Außerdem ist die Abtragsrate von nur gering verdichtetem Material während des Sputterprozesses niedriger als von Material mit höherer relativer Dichte.

Die relative Dichte kann bekanntlich einfach über das archimedische Prinzip mittels Auftriebsverfahren bestimmt werden.

Durch Einbau eines erfindungsgemäßen Sputtertargets in unterschiedlichen Beschichtungsanlagen sowie für die Beschichtung von Substraten unterschiedlicher Geometrien werden verschiedene geometrische Anforderungen an ein erfindungsgemäßes Sputtertarget gestellt. So kann ein solches in Form eines Flachtargets, beispielsweise als Platte oder Scheibe, als Stange, als Rohrtarget oder als anderer komplex geformter Körper vorliegen.

Bevorzugt ist ein erfindungsgemäßes Sputtertarget ein rohrförmiges Sputtertarget.

Durch eine Ausführung als Rohrtarget ist eine erhöhte mögliche Ausnutzung im Vergleich zu Flachtargets gegeben. Durch eine die Ausführung als Rohrtarget ergeben sich weiters besondere Vorteile in Bezug auf die Eigenschaften des Sputtertargets. Durch das besonders günstige Oberfläche zu Volumenverhältnis, insbesondere bei niedrigeren Wandstärken ergibt sich ein besonders gutes Ausgasverhalten während des Herstellverfahrens. So können besonders niedrige Gehalte gasförmiger Verunreinigungen, insbesondere Sauerstoff verwirklicht werden.

Weiter bevorzugt handelt es sich bei einem erfindungsgemäßen Sputtertarget um ein einteiliges Rohrtarget.

Durch die bevorzugte Ausführung als einteiliges Rohrtarget können besonders homogene Schichten auf großflächige Substrate abgeschieden werden, da keine Diskontinuitäten (beispielsweise Fugen, Hinterschneidungen, Rückstände von Lotmaterial, Verunreinigungen im Fugenbereich) zwischen einzelnen Targetstücken (Segmenten) vorhanden sind.

Durch die Ausführung als einteiliges Rohrtarget können Verschiebungen einzelner Targetstücke durch unterschiedliche Temperaturen oder Temperaturzyklen während des Beschichtungsprozesses im Gegensatz zu mehrteilig ausgeführten Rohrtargets vermieden werden. Zusätzlich ist die Homogenität des Targetmaterials in Bezug auf die chemische Reinheit oder die Mikrostruktur bei einteilig ausgeführten Rohrtargets besser als bei mehrteilig ausgeführten Rohrtargets.

Ein erfindungsgemäßes Sputtertarget kann jedoch nicht nur als einteiliges Rohrtarget ausgeführt werden. So kann dieses sowohl als ein- oder mehrteiliges Rohrtarget vorliegen als auch über die Länge verschiedene Bereiche mit unterschiedlichen Außendurchmessern oder relativen Dichten aufweisen ("Hundeknochen"-/"Dog Bone"-Target). Mit einer solchen Ausführungsform kann beispielsweise ein ungleichmäßiger Abtrag des Sputtertargets an den Enden des Targetmaterials ("cross-corner Effekt") reduziert oder weitgehend vermieden werden. Auch ein Target mit Bereichen unterschiedlicher Durchmesser kann sowohl ein- als auch mehrteilig ausgeführt sein.

Weiters kann ein erfindungsgemäßes Sputtertarget eine korrosionsbeständige Schutzvorrichtung beispielsweise in Form einer Lackierung oder Kunststoffbeschichtung zumindest an Teilen des Innendurchmessers aufweisen.

Ein erfindungsgemäßes Sputtertarget weist bevorzugt einen an einer Schnittfläche des Targetmaterials gemessenen Flächenanteil an W-Phase zwischen 15% und 45% auf.

Ein Flächenanteil an W-Phase von kleiner 15% kann bereits mit einem erhöhten Anteil an spröder Ni₄W Phase oder ferromagnetischer Ni-Phase einher gehen und demnach zu schlechterem Sputterverhalten sowie im ersten Fall auch zu verringerter Zähigkeit des Targetmaterials führen. Flächenanteile an W-Phase von größer 45% können sich bereits negativ auf die Härte des Targetmaterials und die Verarbeitbarkeit auswirken.

Der Phasenanteil der W-Phase wird ebenso wie der Flächenanteil der intermetallischen Phasen über geeignete Auswertung eines metallographischen Schliffbildes wie oben beschrieben bestimmt.

Ein erfindungsgemäßes Sputtertarget weist bevorzugt eine durchschnittliche Korngröße der W-Phase von kleiner 40µm, weiter bevorzugt kleiner 20µm, auf.

Eine durchschnittliche Korngröße der W-Phase von kleiner 40µm, weiter bevorzugt kleiner 20µm, führt zu einem besonders gleichmäßigen Sputterverhalten und damit zur Abscheidung besonders homogener Schichten mit besonders gleichmäßiger Dicke. Zusätzlich wird die Kerbwirkung der W-Phase - damit gering gehalten und in Folge eine ausreichende Zähigkeit des Targetmaterials optimal gewährleistet.

Agglomerate aus mehreren Körnern der W-Phase können Ausmaße von 40µm im Durchmesser überschreiten, solche Agglomerate sind jedoch nicht als einzelne Körner der W-Phase in einem erfindungsgemäßen Sputtertarget zu verstehen.

Die durchschnittliche Korngröße der W-Phase kann einfach über ein Linienschnittverfahren, wie beispielsweise in der ASTM E112-12 angegeben, an einem metallographischen Schliffbild bestimmt werden.

Ein erfindungsgemäßes Sputtertarget weist bevorzugt eine in der Ni(W)-Phase vorliegende Textur von <110> parallel zur Hauptverformungsrichtung auf.

Ein erfindungsgemäßes Sputtertarget weist bevorzugt eine in der W-Phase vorliegende Textur von <100> parallel zur Hauptverformungsrichtung oder <111> parallel zur Hauptverformungsrichtung bzw. Anteile beider genannter Texturkomponenten parallel zur Hauptverformungsrichtung auf.

Im bevorzugten Fall eines rohrförmigen Sputtertargets, insbesondere eines einteiligen Rohrtargets ist die Radialrichtung die Hauptverformungsrichtung. Im Fall eines plattenförmigen Targets ist die Normalenrichtung die Hauptverformungsrichtung.

Die Textur eines kristallinen Werkstoffes kann bekanntlich über eine Auswertung mittels kommerziell erhältlicher EBSD (Electron Backscatter Diffraction = Rückstreuelektronenbeugung)-Software in einem Rasterelektronenmikroskop gemessen werden. Im vorliegenden Fall mehrerer unterschiedlicher möglicher Phasen mit unterschiedlicher Kristallographie kann die Textur jeder einzelnen Phase (z.B. W-Phase, Ni(W)-Phase) bestimmt werden. Die Textur der Ni(W)-Phase hat sich als am besten geeignet für eine Charakterisierung eines erfindungsgemäßen Sputtertargets herausgestellt, da diese besonders gleichmäßig und stabil im Zuge einer optionalen thermomechanischen Behandlung als Teil eines erfindungsgemäßes Herstellverfahren einstellbar ist. Zusätzlich findet eine Verformung im Zuge einer optionalen thermomechanischen Behandlung bevorzugt in dieser Phase statt, wodurch sich die gewünschte Textur besonders reproduzierbar einstellen lässt.

Ein erfindungsgemäßes W-Ni Sputtertarget wird bevorzugt zur Abscheidung einer elektrochromen Schicht verwendet. Damit kann auf Sputtern von mehreren unterschiedlichen Sputtertargets (Co-Sputtern) verzichtet werden. Außerdem ist die Beschichtung großflächiger Substrate wie beispielsweise Flachglas durch die bevorzugte Ausführung als rohrförmiges Sputtertarget, weiter bevorzugt als einteiliges Rohrtarget dabei besonders begünstigt.

Andere mögliche bevorzugte Verwendungen für erfindungsgemäße W-Ni Sputtertargets sind die Abscheidung von Solar Absorber Schichten, Schutzschichten gegen Hochtemperaturoxidation oder Diffusionsbarriereschichten.

Ein erfindungsgemäßes Verfahren zur Herstellung eines W-Ni Sputtertargets über die pulvermetallurgische Route ist dadurch gekennzeichnet dass es zumindest folgende Schritte enthält:
- Kompaktierschritt bei welchem eine Pulvermischung aus W-Pulver und Ni-Pulver durch die Anwendung von Druck, Temperatur oder Druck und Temperatur zu einem Rohling kompaktiert wird.
- Abkühlschritt bei welchem der erhaltene Rohling zumindest in einem Temperaturbereich zwischen 900 und 750°C mit einer Abkühlrate größer 30K/min abgekühlt wird.

Ein Kompaktierschritt als Teil eines erfindungsgemäßen Verfahren zur Herstellung eines W-Ni Sputtertargets führt dazu, dass eine entsprechende Pulvermischung durch die Anwendung von Druck, Temperatur oder Druck und Temperatur zu einem Rohling kompaktiert und verdichtet wird. Dies kann durch verschieden ausgestaltete Prozessschritte erfolgen, beispielsweise durch Pressen und Sintern, Heißpressen, Kaltisostatischpressen, Heißisostatischpressen oder Spark Plasma Sintern (SPS) oder einer Kombination aus diesen oder weiteren Verfahren zur Kompaktierung von Pulvermischungen.

Das Herstellen einer für ein erfindungsgemäßes Verfahren verwendbaren Pulvermischung erfolgt bevorzugt über die Einwaage der entsprechenden Mengen an W- sowie Ni-Pulver und Mischen in einem geeigneten Mischaggregat bis eine homogene Verteilung der Komponenten in der Pulvermischung gewährleistet ist. Als Pulvermischung im Sinne der vorliegenden Erfindung sind auch vor- oder anlegierte Pulver zu verstehen, die die Komponenten W und Ni enthalten.

Eine derart hergestellte Pulvermischung wird für die Implementierung des Kompaktierschritts bevorzugt in eine Form gefüllt. Als Form werden hier sowohl die Matrize oder der Schlauch beim kaltisostatischen Pressen, die Matrize einer Heißpresse oder einer Spark-Plasma-Sinteranlage sowie auch die Kanne beim heißisostatischen Pressen bezeichnet.

Ein Abkühlschritt bei welchem der erhaltene Rohling zumindest in einem Temperaturbereich zwischen 900 und 750°C mit einer Abkühlrate größer 30K/min abgekühlt wird, als Teil eines erfindungsgemäßen Verfahrens zur Herstellung eines W-Ni Sputtertargets, führt dazu, dass das Auftreten, insbesondere die Bildung von unerwünschten intermetallischen Phasen wie zum Beispiel Ni₄W weitgehend vermieden wird. Ein zu hoher Anteil an intermetallischen Phasen in einem mittels eines erfindungsgemäßen Verfahren hergestellten W-Ni Sputtertarget kann einerseits zu einer zum restlichen Target unterschiedlichen Sputterrate, damit zu ungleichmäßigem Abtrag über das Targetmaterial und damit zu Schwankungen in der Dicke der abgeschiedenen Schicht führen. Weiters können im Gefüge des Targetmaterials vorhandene intermetallische spröde Phasen zu Arcing oder verstärkter Partikelbildung führen. Andererseits wird durch die geringe Zähigkeit intermetallischer Phasen die Handhabung eines solchen Sputtertargets erschwert.

Ein solcher Abkühlschritt kann beispielsweise durch eine Abkühlung an Luft, Wasser oder Öl verwirklicht werden. Durch einen solchen Abkühlschritt wird gewährleistet, dass die Bildung intermetallischer Phasen in optimaler Weise vermieden wird und dass das über das Verfahren hergestellte Sputtertarget eine bestmögliche Kombination aus mikrostrukturellen und mechanischen Eigenschaften aufweist.

Weiter bevorzugt ist es, wenn bei einem solchen Abkühlschritt der erhaltene Rohling zumindest in einem Temperaturbereich zwischen 900 und 750°C mit einer Abkühlrate größer 50 K/min abgekühlt wird, da damit die beschriebenen Materialeigenschaften sowie die Mikrostruktur des Targets in besonders optimaler Weise eingestellt werden können.

Noch weiter bevorzugt ist es, wenn bei einem solchen Abkühlschritt der erhaltene Rohling zumindest in einem Temperaturbereich zwischen 1000 und 600°C mit einer Abkühlrate größer 30 K/min, am meisten bevorzugt größer 50 K/min abgekühlt wird, da damit die beschriebenen Materialeigenschaften sowie die Mikrostruktur des Targets in noch weiter optimierter Weise eingestellt werden können.

Es erweist sich als besonders vorteilhaft, wenn in einem erfindungsgemäßen Verfahren zur Herstellung eines W-Ni Sputtertargets der Kompaktierschritt durch Sintern bei Temperaturen von 1100 bis 1450°C verwirklicht wird. Dabei ist unter Sintern ein als druckloses Sintern bezeichneter Sintervorgang bei Drücken von weniger als 2 MPa, bevorzugt bei Drücken geringer als Atmosphärendruck, zu verstehen.

Durch eine Kompaktierung bei diesen Temperaturen ist optimal gewährleistet, dass in der vorliegenden Pulvermischung ein Festphasensintern zu bereits sehr hohen relativen Dichten stattfindet. Bei einer Kompaktierung bei unter 1100°C kann die erreichbare Dichte bereits zu niedrig sein, bei Temperaturen über 1450°C können bereits Einbußen in Bezug auf die mechanische Stabilität des Targetmaterials auftreten. Bei einer Kompaktierung im angegebenen Temperaturbereich wird eine optimale Kombination aus hoher erreichter Dichte und optimalen mechanischen Eigenschaften gewährleistet.

Bei einem erfindungsgemäßen Verfahren zur Herstellung eines W-Ni Sputtertargets findet bevorzugt zwischen dem Kompaktierschritt und dem Abkühlschritt eine thermomechanische oder thermische Behandlung des erhaltenen Rohlings statt. Mit einer solchen thermomechanischen oder thermischen Behandlung können vorteilhafte Eigenschaften wie zum Beispiel eine weitere Erhöhung der Dichte und oder eine weitere Homogenisierung des Gefüges erzeugt werden.

Bevorzugt können durch eine entsprechende thermomechanische oder thermische Behandlung gegebenenfalls doch vorhandene geringe Anteile an intermetallischen Phasen homogen im Gefüge des Targetmaterials verteilt und negative Auswirkungen derselben damit minimiert werden. Durch diese feine Verteilung wird ein noch gleichmäßigerer Abtrag ohne Reliefbildung beim Sputtern gewährleistet.

Besonders vorteilhaft für das Verfahren zur Herstellung eines W-Ni Sputtertargets hat sich herausgestellt, wenn eine angewandte thermomechanische oder thermische Behandlung bei Temperaturen zwischen 970 und 1450°C stattfindet. Eine thermomechanische oder thermische Behandlung im angegebenen Temperaturbereich findet im Zweiphasengebiet W(Ni) + Ni(W) statt und führt im bevorzugten Fall dazu, dass keine oder im Wesentlichen keine Bildung weiterer unerwünschter spröder intermetallischer Phasen auftritt. Im Optimalfall können durch eine solche thermomechanische oder thermische Behandlung auch intermetallische Phasen, die nach der Kompaktierung vorhanden sein können, weitgehend aufgelöst werden.

Durch eine solche weitgehende Vermeidung unerwünschter spröder intermetallischer Phasen kann ein mittels eines erfindungsgemäßen Verfahrens hergestelltes W-Ni Sputtertarget besonders gut umgeformt werden. Dies wiederum vereinfacht die Herstellung großformatiger Sputtertargets und insbesondere langer und bevorzugt einteiliger Rohrtargets und wirkt sich vorteilhaft auf die erreichbare Endgeometrienähe aus.

Geeignete Verfahren für das Aufbringen einer thermomechanischen öder thermischen Behandlung im Rahmen der vorliegenden Erfindung sind zum Beispiel Walzen, Strangpressen, Schmieden, Fließdrücken (Flowforming) oder auch Heißisostatisch Pressen (HIP).

Eine thermomechanische oder thermische Behandlung im Rahmen der vorliegenden Erfindung kann als ein- oder mehrstufiger Prozess durchgeführt werden. Auch eine Kombination aus mehreren geeigneten Verfahren ist möglich. So kann eine thermomechanische oder thermische Behandlung einen oder auch mehrere Teilschritte enthalten, die keine oder im Wesentlichen keine Verformung des Targetmaterials beinhalten.

Sowohl bei einer ein- wie auch bei einer mehrstufigen thermomechanischen oder thermischen Behandlung werden bevorzugt Verformungsraten (Querschnittsreduktion) von zwischen 20 und 80% auf den durch Kompaktierung erhaltenen Rohling aufgebracht. Die angegebenen Verformungsraten können sowohl in einem einzelnen Schritt, als auch über mehrere Schritte verteilt aufgebracht werden.

Bei Verformungsraten von zwischen 20% und 80% kann die erforderliche Dichte des Targetmaterials besonders optimal erreicht werden, zusätzlich dazu sind Verformungsraten von zwischen 20 und 80% in wirtschaftlicher Hinsicht besonders vorteilhaft.

Als besonders vorteilhaft hat sich herausgestellt, wenn eine thermomechanische oder thermische Behandlung in einem erfindungsgemäßen Verfahren zur Herstellung eines W-Ni Sputtertargets mindestens einen Schmiedeschritt enthält.

Durch eine thermomechanische oder thermische Behandlung, enthaltend mindestens einen Schmiedeschritt können besonders gezielt definierte Verformungsraten ins Targetmaterial eingebracht werden. Dadurch kann beispielsweise eine zu starke Verfestigung und in Folge dessen eine Überschreitung der aufbringbaren Umformkräfte vermieden werden.

Durch eine thermomechanische oder thermische Behandlung, enthaltend mindestens einen Schmiedeschritt können gezielt Texturen im Targetmaterial eingestellt werden, die wiederum sowohl die mechanischen Eigenschaften als auch die Sputtereigenschaften des Targetmaterials positiv beeinflussen können.

Weiterhin ist es über einen oder mehrere Schmiedeschritte möglich, die Stärke des umgeformten Materials über die Länge zu variieren und gezielt einzustellen, was insbesondere für eine Erhöhung der Sputterausbeute genutzt werden kann (über die Länge verschiedene Bereiche mit unterschiedlichen Außendurchmessern, "Hundeknochen"-/"Dog Bone"-Target).

Außerdem kann mittels Schmieden eine für eine weitere mechanische Bearbeitung oder auch eine weitere thermomechanische oder thermische Behandlung des Targetmaterials günstige und gleichmäßige Oberflächenqualität, hohe Geradheit und gute Rundheit gewährleistet werden.

Ein Verfahren zur Herstellung eines erfindungsgemäßen Sputtertargets kann weiters folgende Schritte enthalten:
- Mechanische Bearbeitung
- Aufbringen auf ein oder mehrere Stützelemente

Sowohl nach dem Kompaktierschritt, dem Abkühlschritt oder auch nach einer optionalen thermomechanischen oder thermischen Behandlung kann eine mechanische Bearbeitung des erhaltenen Rohlings oder Targetmaterials erwünscht oder erforderlich sein. Durch eine derartige mechanische Bearbeitung, zum Beispiel über Zerspanen, Schleifen, Polieren können sowohl die Endgeometrie eingestellt oder präzisiert, als auch zum Beispiel eine bestimmte gewünschte Oberflächengüte eingestellt werden.

Ein durch ein erfindungsgemäßes Verfahren hergestelltes Sputtertarget kann weiters auf ein oder mehrere entsprechende Stützelemente aufgebracht werden. Dies kann zum Beispiel durch einen Bonding-Schritt erfolgen. Entsprechende Stützelemente können beispielsweise Rückplatten unterschiedlicher Geometrie oder im bevorzugten Fall eines rohrförmigen Sputtertargets, insbesondere einteiligen Rohrtargets ein Stützrohr, aber auch nicht durch das gesamte Rohr durchgängige Stützelemente wie Stutzen, Flansche oder auch anders ausgebildete Anschlussstücke und auch mehrteilige Stützrohre oder -elemente sein.

Entsprechende Stützelemente können zum Beispiel aus Edelstahl, Cu, Cu-Legierungen, Ti oder Ti-Legierungen gefertigt sein. Es sind aber auch andere Materialien für die Herstellung entsprechender Stützelemente verwendbar.

Für einen Bonding-Schritt werden bevorzugt Elemente oder Legierungen mit niedrigem Schmelzpunkt, zum Beispiel Indium verwendet. Zusätzlich kann optional ein Haftvermittler, zum Beispiel Ni, verwendet werden, um eine bessere Benetzung zu gewährleisten. Statt mittels eines Bonding-Schritts kann das Aufbringen auf entsprechende Stützelemente auch über Löten oder Kleben oder auch eine formschlüssige Verbindung wie zum Beispiel durch Aufschrauben oder Klemmen erfolgen.

Auch das Aufbringen einer korrosionsbeständigen Schutzvorrichtung beispielsweise in Form einer Lackierung oder Kunststoffbeschichtung zumindest an Teilen des Innendurchmessers des Targetmaterials ist als weiterer Schritt im Rahmen eines erfindungsgemäßen Verfahrens zur Herstellung eines W-Ni Sputtertargets möglich.

In einem bevorzugten Fall wird mittels eines erfindungsgemäßen Verfahrens zur Herstellung eines W-Ni Sputtertargets ein Sputtertarget enthaltend zwischen 45 und 75wt% W, Rest Ni, sowie übliche Verunreinigungen hergestellt. In diesem Fall wird durch die Anwendung des erfindungsgemäßen Verfahrens gewährleistet, dass ein erzeugtes W-Ni Sputtertarget Ni(W)-Phase, W-Phase sowie keinen oder unter 10% an einer Schnittfläche des Targetmaterials gemessenen mittleren Flächenanteil intermetallischer Phasen enthält. Als Flächenanteil ist hier der mittlere Flächenanteil, der als arithmetisches Mittel aus 5 Messungen des Flächenanteils gemessen an 5 Bildausschnitten mit einer Größe von 100 x 100µm eines metallographischen Schliffes, aufgenommen mit 1000-facher Vergrößerung, berechnet wird, zu verstehen.

Durch ein erfindungsgemäßes Verfahren zur Herstellung eines W-Ni Sputtertargets können in einem durch dieses Verfahren hergestellten W-Ni Sputtertarget relative Dichten von mehr als 96% gewährleistet werden. In besonders bevorzugten Ausführungen der Erfindung können relative Dichten von mehr als 99% erreicht werden.

Auch die Reinheit und die mechanischen Eigenschaften des resultierenden Targetmaterials werden durch ein erfindungsgemäßes Verfahren zur Herstellung eines W-Ni Sputtertargets optimiert.

So führt ein erfindungsgemäßes Verfahren zu sehr niedrigen Gehalten an Verunreinigungen in damit hergestellten Sputtertargets, zum Beispiel einem bevorzugten Sauerstoffgehalt von unter 100 µg/g, besonders bevorzugt unter 90 µg/g, weiter bevorzugt unter 75 µg/g, noch weiter bevorzugt unter 50 µg/g. Die weitgehende Vermeidung der Bildung spröder intermetallischer Phasen führt weiters auch bevorzugt zu einer optimierten Härte eines mittels eines erfindungsgemäßen Verfahrens hergestellten W-Ni Sputtertargets.

In einem bevorzugten Fall wird mittels eines erfindungsgemäßen Verfahrens zur Herstellung eines W-Ni Sputtertargets ein Sputtertarget enthaltend zwischen 45 und 75wt% W, Rest Ni, sowie übliche Verunreinigungen hergestellt. In diesem Fall werden durch ein erfindungsgemäßes Verfahren bevorzugt Härten von unter 500 HV10 erreicht.

In einem bevorzugten Fall wird mittels eines erfindungsgemäßen Verfahrens zur Herstellung eines W-Ni Sputtertargets ein Sputtertarget enthaltend zwischen 45 und 75wt% W, Rest Ni, sowie übliche Verunreinigungen hergestellt. In diesem Fall wird durch ein erfindungsgemäßes Verfahren ein an einer Schnittfläche des Targetmaterials gemessener Flächenanteil an W-Phase zwischen 15% und 45% erreicht.

In einem bevorzugten Fall wird mittels eines erfindungsgemäßen Verfahrens zur Herstellung eines W-Ni Sputtertargets ein Sputtertarget enthaltend zwischen 45 und 75wt% W, Rest Ni, sowie übliche Verunreinigungen hergestellt. In diesem Fall wird durch ein erfindungsgemäßes Verfahren eine durchschnittliche Korngröße der W-Phase von kleiner 40µm, weiter bevorzugt kleiner 20µm, erreicht.

Bei Anwendung eines erfindungsgemäßen Verfahrens zur Herstellung eines W-Ni Sputtertargets bei welchem im bevorzugten Fall eine thermomechanische Behandlung stattfindet, weist ein damit hergestelltes W-Ni Sputtertarget eine in der Ni(W)-Phase vorliegende Textur von <110> parallel zur Hauptverformungsrichtung auf.

Bei Anwendung eines erfindungsgemäßen Verfahrens zur Herstellung eines W-Ni Sputtertargets bei welchem im bevorzugten Fall eine thermomechanische Behandlung stattfindet, weist ein damit hergestelltes W-Ni Sputtertarget eine in der W-Phase vorliegende Textur von <100> parallel zur Hauptverformungsrichtung oder <111> parallel zur Hauptverformungsrichtung bzw. Anteile beider genannter Texturkomponenten parallel zur Hauptverformungsrichtung auf.

Im bevorzugten Fall eines rohrförmigen Sputtertargets, insbesondere eines einteiligen Rohrtargets ist die Radialrichtung die Hauptverformungsrichtung. Im Fall eines plattenförmigen Targets ist die Normalenrichtung die Hauptverformungsrichtung.

Im Folgenden wird die Erfindung an Hand von Herstellungsbeispielen und Figuren näher erläutert.

### AUSFÜHRUNGSBEISPIELE

Die Ausführungsbeispiele sind in Tabelle 1 zusammengefasst.

**Tabelle 1: * markiert erfindungsgemäße Beispiele**

| Beispiel | W [wt%] | Ni [wt%] | Sintertemperatur [°C] | Thermomech. oder therm. Behandlung, Abkühlung | Umformgrad [%] | Dichte [%] | Fläche W-Phase [%] | Korngröße W-Phase [µm] | Fläche Intermet. Phase [%] | Textur Ni(W) | Härte [HV10] | O Gehalt [µg/g] |
|---|---|---|---|---|---|---|---|---|---|---|---|---|
| 1 * | 60 | 40 | 1350 | Schmieden, 1300°C, Abkühlung an Luft | 25 | 99,7 | 30 | 15 | 7 | <110> | 344 | 9 |
| 2 * | 60 | 40 | 1350 | Schmieden, 1250°C, Glühen 1000°C 1h, Abkühlung an Luft | 25 | 99,7 | 29 | 14 | <5 | <110> | 331 | 11 |
| 3 * | 70 | 30 | 1350 | Schmieden, 1300°C, Abkühlung an Luft | 50 | 99,5 | 39 | 19 | 8 | <110> | 442 | 70 |
| 4 | 43 | 57 | 1350 | keine, Ofenabkühlung | 0 | 78 | 8 | 18 | 12 | keine | 163 | 268 |
| 5 | 60 | 40 | 1200 | keine, Ofenabkühlung | 0 | 77 | 30 | 15 | 15 | keine | 165 | 96 |
| 6 | 60 | 40 | 1000 | Schmieden, 1300°C (abgebfochen), Ofenabkühlung | 25 | 65 | - | - | - | - | 74 | 120 |

### Beispiel 1:

Als Rohstoffe wurden W-Metallpulver mit einer Korngröße nach Fisher von 4µm und Ni-Metallpulver mit einer Korngröße nach Fisher von 4,2µm verwendet. Die Pulver wurden in einem Verhältnis von 60 wt% W und 40 wt% Ni in einen geschlossenen Behälter gefüllt und für 1 h in einem Schüttelmischer durchmischt.

In einem einseitig geschlossenen Gummischlauch mit einem Durchmesser von 300 mm wurde ein Stahldorn mit einem Durchmesser von 141 mm in der Mitte positioniert. Die Pulvermischung wurde in den Zwischenraum zwischen Stahlkern und Gummiwandung gefüllt und der Gummischlauch an dessen offenen Ende mittels einer Gummikappe verschlossen. Der verschlossene Gummischlauch wurde in einer kaltisostatischen Presse positioniert und bei einem Druck von 200 MPa zu einem Grünling in Form einer Rohrluppe mit einer relativen Dichte von 61% und einem Außendurchmesser von 240 mm verpresst.

Der so hergestellte Grünling wurde in einem Indirektsinterofen bei einer Temperatur von 1350°C gesintert. Die relative Dichte nach dem Sintern betrug 95%.

Nach dem Sintern wurde die Rohrrohluppe allseitig mechanisch auf eine Geometrie von 200 mm Außendurchmesser, 127 mm Innendurchmesser und 900 mm Länge bearbeitet.

In weiterer Folge wurde die Rohrluppe nach Anwärmung bei einer Temperatur von 1300°C über einen Dorn geschmiedet, wodurch ein Rohr mit einer Länge von 1200 mm, einem Außendurchmesser von 180 mm und einem Innendurchmesser von 120 mm entstand, welches an Luft abgekühlt wurde. Im Temperaturbereich zwischen 900 und 750°C wurde eine Abkühlgeschwindigkeit von 37K/min realisiert.

Die Dichte nach dem Schmieden betrug 99,7%, die Härte des Targetmaterials 344 HV10. Es wurde ein Sauerstoffgehalt von 9 µg/g gemessen.
Bei einer Messung der Textur konnte eine Vorzugsorientierung in der <110> Richtung in der Ni(W)-Phase festgestellt werden. Die Fläche der W-Phase betrug 30%, deren durchschnittliche Korngröße 15µm. Die Flächenanteile an intermetallischer Phase betrugen 7%.

### Beispiel 2:

Analog zu Beispiel 1 wurde eine Rohrluppe hergestellt:
In weiterer Folge wurde die Rohrluppe bei einer Temperatur von 1250°Cüber einen Dorn geschmiedet, wodurch ein Rohr mit einer Länge von 1200mm, einem Außendurchmesser von 180 mm und einem Innendurchmesser von 120 mm entstand. Weiters wurde eine Glühbehandlung für eine Stunde bei 1000°C, gefolgt von einer Abkühlung an Luft durchgeführt. Im Temperaturbereich zwischen 900 und 750°C wurde eine Abkühlgeschwindigkeit von 58K/min realisiert.

Danach betrug die Dichte 99,7%, die Härte des Targetmaterials 331 HV10. Es wurde ein Sauerstoffgehalt von 11 µg/g gemessen.

Bei einer Messung der Textur konnte eine Vorzugsorientierung in der <110> Richtung in der Ni(W)-Phase festgestellt werden. Die Fläche der W-Phase betrug 29%, deren durchschnittliche Korngröße 14µm. Die Flächenanteile an intermetallischer Phase betrugen <5%, das heißt, es konnten keine Anteile intermetallischer Phase mittels XRD gemessen werden.

### Beispiel 3:

Analog zu den Beispielen 1 und 2 wurde eine Rohrluppe hergestellt, allerdings wurden W- und Ni-Pulver in einem Verhältnis von 70 wt% W und 30 wt% Ni verwendet.

In weiterer Folge wurde die Rohrluppe bei einer Temperatur von 1300°C über einen Dorn geschmiedet, wodurch ein Rohr mit einer Länge von 1200 mm, einem Außendurchmesser von 180 mm und einem Innendurchmesser von 120 mm entstand, welches an Luft abgekühlt wurde. Im Temperaturbereich zwischen 900 und 750°C wurde eine Abkühlgeschwindigkeit von 34K/min realisiert.

Danach betrug die Dichte 99,5%, die Härte des Targetmaterials 442 HV10. Es wurde ein Sauerstoffgehalt von 70 µg/g gemessen.

Bei einer Messung der Textur konnte eine Vorzugsorientierung in der <110> Richtung in der Ni(W)-Phase festgestellt werden. Die Fläche der W-Phase betrug 39%, deren durchschnittliche Größe 19µm. Die Flächenanteile an intermetallischer Phase betrugen 8%.

### Beispiel 4:

Analog zu den Beispielen 1 bis 3 wurde eine Rohrluppe hergestellt, allerdings wurden W- und Ni-Pulver in einem Verhältnis von 43 wt% W und 57 wt% Ni verwendet. Es wurde keine thermomechanische oder thermische Behandlung durchgeführt. Nach dem Sintern wurde im Ofen abgekühlt, wobei im Temperaturbereich zwischen 900 und 750°C eine Abkühlrate von etwa 10K/min erreicht wurde. Die Dichte nach dem Sintern betrug 78%, die Härte des Targetmaterials 163 HV10. Der niedrige Härtewert ist durch die geringe Dichte zu begründen. Es wurde ein Sauerstoffgehalt von 268 µg/g gemessen.

Die Fläche der W-Phase betrug 8%, deren durchschnittliche Korngröße 18µm. Die Flächenanteile an intermetallischer Phase betrugen 12%.

### Beispiel 5:

Analog zu den Beispielen 1 und 2 wurde eine Rohrluppe hergestellt, allerdings wurde bei einer Temperatur von 1200°C gesintert. Es wurde keine thermomechanische oder thermische Behandlung durchgeführt. Nach dem Sintern wurde im Ofen abgekühlt, wobei im Temperaturbereich zwischen 900 und 750°C eine Abkühlrate von etwa 10K/min erreicht wurde. Die Dichte nach dem Sintern betrug 77%, die Härte des Targetmaterials 165 HV10. Der niedrige Härtewert ist durch die geringe Dichte zu begründen. Es wurde ein Sauerstoffgehalt von 96 µg/g gemessen.

Die Fläche der W-Phase betrug 30%, deren durchschnittliche Größe 15µm. Die Flächenanteile an intermetallischer Phase betrugen 15%.

### Beispiel 6

Analog zu den Beispielen 1 und 2 wurde eine Rohrluppe hergestellt, allerdings wurde bei einer Temperatur von 1000°C gesintert. Nach dem Sintern wurde im Ofen abgekühlt, wobei im Temperaturbereich zwischen 900 und 750°C eine Abkühlrate von etwa 10K/min erreicht wurde. Die Dichte nach dem Sintern betrug 77%, die Härte des Targetmaterials 74 HV10. Es wurde ein Sauerstoffgehalt von 120 µg/g gemessen. In weiterer Folge wurde versucht die Rohrluppe bei 1300°C über einen Dorn zu schmieden, der Versuch wurde jedoch abgebrochen, da das Targetmaterial mechanisch versagte. Es konnten keine Werte für Textur sowie Phasenanteile und Korngrößen bestimmt werden.

Von den Figuren zeigen:
- Figur 1:: Phasendiagramm des Systems Ni-W (Quelle: ASM International's Binary Alloy Phase Diagrams, Second Edition), erfindungsgemäßer Zusammensetzungsbereich markiert.
- Figur 2:: Gefüge eines nicht erfindungsgemäßen W-Ni Sputtertargets mit 60 wt% W, 40 wt% Ni, geätzt mit einer Lösung aus 85ml NH₄OH 25%ig + 5ml H₂O₂. Flächenanteil intermetallische Phase 11,7%, Flächenanteil W-Phase 29,2%, Rest Ni(W).

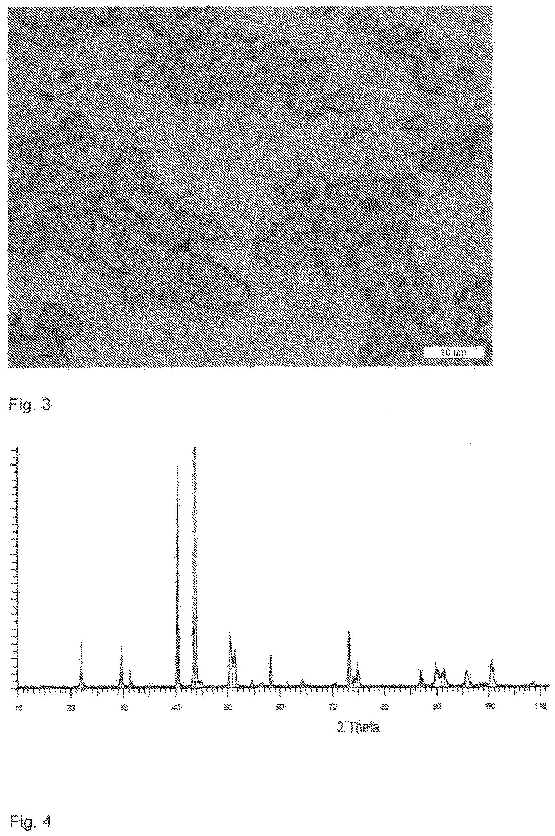

- Figur 3:: Gefüge eines erfindungsgemäßen W-Ni Sputtertargets mit 60 wt% W, 40 wt% Ni, geätzt mit einer Lösung aus 85ml NH₄OH 25%ig + 5ml H₂O₂ Kein auswertbarer Flächenanteil intermetallische Phase, Flächenanteil W-Phase 29,5%, Rest Ni(W).
- Figur 4:: Röntgendiffraktogramm einer Probe eines nicht erfindungsgemäßen W-Ni Sputtertargets, Anteile intermetallische Phase (Ni₄W) größer 10% (Fläche).

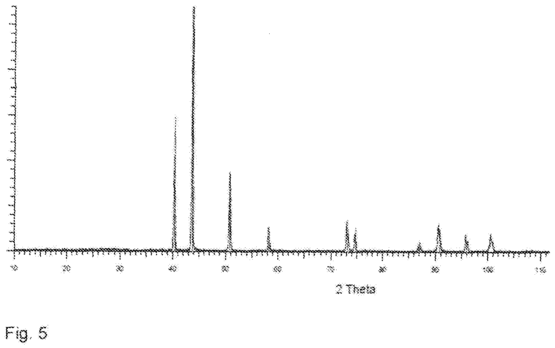

- Figur 5:: Röntgendiffraktogramm einer Probe eines erfindungsgemäßen W-Ni Sputtertargets, keine Anteile intermetallische Phase (Ni₄W) detektierbar.

Für die Auswertung der gezeigten Diffraktogramme wurden die JCPDS Karten 03-065-2673 (Ni₄W), 00-004-0806 (W) sowie 03-065-4828 (Ni₁₇W₃, entsprechend Ni(W), mit W gesättigter Ni-Mischkristall) verwendet.

## Patentansprüche

1. Sputtertarget bestehend aus zwischen 45 und 75wt% W, Rest Ni, sowie übliche Verunreinigungen, **dadurch gekennzeichnet, dass** es Ni(W)-Phase, W-Phase sowie keinen oder unter 10% an einer Schnittfläche des Targetmaterials gemessenen mittleren Flächenanteil intermetallischer Phasen enthält.

2. Sputtertarget nach Anspruch 1, **dadurch gekennzeichnet, dass** der Sauerstoffgehalt unter 100 µg/g liegt.

3. Sputtertarget nach einem der Ansprüche 1 oder 2, **dadurch gekennzeichnet, dass** dessen Härte unter 500 HV10 liegt.

4. Sputtertarget nach einem der Ansprüche 1 bis 3, **dadurch gekennzeichnet, dass** es ein rohrförmiges Sputtertarget ist.

5. Sputtertarget nach einem der Ansprüche 1 bis 4, **dadurch gekennzeichnet, dass** es sich um ein einteiliges Rohrtarget handelt.

6. Sputtertarget nach einem der Ansprüche 1 bis 5, **dadurch gekennzeichnet, dass** es einen an einer Schnittfläche des Targetmaterials gemessenen Flächenanteil an W-Phase zwischen 15% und 45% aufweist.

7. Sputtertarget nach einem der Ansprüche 1 bis 6, **dadurch gekennzeichnet, dass** es eine durchschnittliche Korngröße der W-Phase von kleiner 40 µm aufweist.

8. Sputtertarget nach einem der Ansprüche 1 bis 7, **dadurch gekennzeichnet, dass** es eine in der Ni(W)-Phase vorliegende Textur von <110> parallel zur Hauptverformungsrichtung aufweist.

9. Verwendung eines Sputtertargets nach einem der Ansprüche 1 bis 8 zur Abscheidung einer elektrochromen Schicht.

10. Verwendung eines Sputtertargets nach einem der Ansprüche 1 bis 8 zur Abscheidung von Solar Absorber Schichten, Schutzschichten gegen Hochtemperaturoxidation oder Diffusionsbarriereschichten.

11. Verfahren zur Herstellung eines W-Ni Sputtertargets über die pulvermetallurgische Route, **dadurch gekennzeichnet, dass** es zumindest folgende Schritte enthält:
- Kompaktierschritt bei welchem eine Pulvermischung aus W-Pulver und Ni-Pulver durch die Anwendung von Druck, Temperatur oder Druck und Temperatur zu einem Rohling kompaktiert wird.
- Abkühlschritt bei welchem der erhaltene Rohling zumindest in einem Temperaturbereich zwischen 900 und 750°C mit einer Abkühlrate größer 30K/min abgekühlt wird.

12. Verfahren zur Herstellung eines W-Ni Sputtertargets nach Anspruch 11, **dadurch gekennzeichnet, dass** der Kompaktierschritt durch Sintern bei Temperaturen von 1100 bis 1450°C verwirklicht wird.

13. Verfahren zur Herstellung eines W-Ni Sputtertargets nach einem der Ansprüche 11 oder 12, **dadurch gekennzeichnet, dass** zwischen dem Kompaktierschritt und dem Abkühlschritt eine thermomechanische oder thermische Behandlung des erhaltenen Rohlings stattfindet.

14. Verfahren zur Herstellung eines W-Ni Sputtertargets nach Anspruch 13, **dadurch gekennzeichnet, dass** die thermomechanische oder thermische Behandlung bei Temperaturen zwischen 970 und 1450°C stattfindet.

15. Verfahren zur Herstellung eines W-Ni Sputtertargets nach einem der Ansprüche 13 oder 14, **dadurch gekennzeichnet, dass** die thermomechanische oder thermische Behandlung mindestens einen Schmiedeschritt enthält.

## Claims

1. Sputtering target consisting of from 45 to 75% by weight of W, balance Ni and normal impurities, **characterized in that** it contains Ni(W) phase, W phase and no or less than 10% by area on average of intermetallic phases measured at a cross section of the target material.

2. Sputtering target according to Claim 1, **characterized in that** the oxygen content is less than 100 µg/g.

3. Sputtering target according to either Claim 1 or 2, **characterized in that** its hardness is less than 500 HV10.

4. Sputtering target according to any of Claims 1 to 3, **characterized in that** it is a tubular sputtering target.

5. Sputtering target according to any of Claims 1 to 4, **characterized in that** it is a one-piece tubular target.

6. Sputtering target according to any of Claims 1 to 5, **characterized in that** it has a proportion by area of W phase measured at a cross section of the target material in the range from 15% to 45%.

7. Sputtering target according to any of Claims 1 to 6, **characterized in that** it has an average grain size of the W phase of less than 40 µm.

8. Sputtering target according to any of Claims 1 to 7, **characterized in that** it has a texture of <110> parallel to the main deformation direction in the Ni(W) phase.

9. Use of a sputtering target according to any of Claims 1 to 8 for deposition of an electrochromic layer.

10. Use of a sputtering target according to any of Claims 1 to 8 for deposition of solar absorber layers, protective layers against high-temperature oxidation or diffusion barrier layers.

11. Process for producing a W-Ni sputtering target via the powder-metallurgical route, **characterized in that** it comprises at least the following steps:
- a compacting step in which a powder mixture of W powder and Ni powder is compacted by application of pressure, heat or pressure and heat to give a blank;
- a cooling step in which the resulting blank is cooled at a cooling rate of greater than 30 K/min at least in a temperature range from 900 to 750°C.

12. Process for producing a W-Ni sputtering target according to Claim 11, **characterized in that** the compacting step is effected by sintering at temperatures of from 1100 to 1450°C.

13. Process for producing a W-Ni sputtering target according to either Claim 11 or 12, **characterized in that** a thermomechanical or thermal treatment of the blank obtained takes place between the compacting step and the cooling step.

14. Process for producing a W-Ni sputtering target according to Claim 13, **characterized in that** the thermomechanical or thermal treatment takes place at temperatures in the range from 970 to 1450°C.

15. Process for producing a W-Ni sputtering target according to either Claim 13 or 14, **characterized in that** the thermomechanical or thermal treatment includes at least one forging step.

## Revendications

1. Cible de pulvérisation composée d'entre 45 et 75 % massiques de W, de reste de Ni ainsi que des impuretés habituelles, **caractérisée en ce qu'**elle contient une phase de Ni(W), une phase de W ainsi qu'une part surfacique moyenne nulle, ou inférieure à 10 %, mesurée au niveau d'une interface du matériau cible, de phases intermétalliques.

2. Cible de pulvérisation selon la revendication 1, **caractérisée en ce que** la teneur en oxygène est inférieure à 100 µg/g.

3. Cible de pulvérisation selon l'une des revendications 1 ou 2, **caractérisée en ce que** sa dureté est inférieure à 500 HV10.

4. Cible de pulvérisation selon l'une des revendications 1 à 3, **caractérisée en ce qu'**elle est une cible de pulvérisation tubulaire.

5. Cible de pulvérisation selon l'une revendications 1 à 4, **caractérisée en ce qu'**il s'agit d'une cible tubulaire monobloc.

6. Cible de pulvérisation selon l'une des revendications 1 à 5, **caractérisée en ce qu'**elle est présente une part surfacique de phase de W comprise entre 15 % et 45 %, mesurée au niveau d'une interface du matériau cible.

7. Cible de pulvérisation selon l'une des revendications 1 à 6, **caractérisée en ce qu'**elle présente une taille des grains moyenne de la phase de W inférieure à 40 µm.

8. Cible de pulvérisation selon l'une des revendications 1 à 7, **caractérisée en ce qu'**elle présente une texture de <110> présente dans la phase de Ni(W) parallèle au sens de déformation principal.

9. Utilisation d'une cible de pulvérisation selon l'une des revendications 1 à 8 pour séparer une couche électrochrome.

10. Utilisation d'une cible de pulvérisation selon l'une des revendications 1 à 8 pour séparer des couches de matériau absorbant solaire, des couches de protection contre l'oxydation à haute température ou des couches de barrière de diffusion.

11. Procédé de fabrication d'une cible de pulvérisation au W-Ni par la voie de la métallurgie des poudres, **caractérisé en ce qu'**il comprend au moins les étapes suivantes :
- une étape de compactage lors de laquelle un mélange de poudres composé de poudre de W et de poudre de Ni est compacté en une ébauche en utilisant la pression, la température ou la pression et la température,
- une étape de refroidissement lors de laquelle l'ébauche obtenue est refroidie au moins dans une plage de température entre 900 et 750 °C avec un taux de refroidissement supérieur à 30 K/min.

12. Procédé de fabrication d'une cible de pulvérisation au W-Ni selon la revendication 11, **caractérisé en ce que** l'étape de compactage est réalisée par frittage à des températures de 1100 à 1450 °C.

13. Procédé de fabrication d'une cible de pulvérisation au W-Ni selon l'une des revendications 11 ou 12, **caractérisé en ce qu'**un traitement thermomécanique ou thermique de l'ébauche obtenue a lieu entre l'étape de compactage et l'étape de refroidissement.

14. Procédé de fabrication d'une cible de pulvérisation au W-Ni selon la revendication 13, **caractérisé en ce que** le traitement thermomécanique ou thermique a lieu à des températures entre 970 et 1450 °C.

15. Procédé de fabrication d'une cible de pulvérisation au W-Ni selon l'une des revendications 13 ou 14, **caractérisé en ce que** le traitement thermomécanique ou thermique contient au moins une étape de forgeage.
